# EUROPEAN PATENT SPECIFICATION

(11) **EP 1 702 999 B1**
(45) Date of publication and mention of the grant of the patent: **12.08.2009**
(21) Application number: 06005161.2
(22) Date of filing: 14.03.2006
(51) Int. Cl.: C23C 16/455

(54) **ALD process for deposition of thin films**
ALD-Verfahren zur Herstellung dünner Schichten
Procédé ALD de fabrication de couches minces.

(30) Priority: 16.03.2005 KR 2005021875
(43) Date of publication of application: 20.09.2006
(73) Proprietor: IPS Ltd, Pyungtaek-si, Kyungki-do (KR)
(72) Inventor: Park, Young Hoon, Pyungtaek-city Kyungki-do (KR); Lee, Sahng Kyu, Pyungtaek-city Kyungki-do (KR); Lee, Ki Hoon, Pyungtaek-city Kyungki-do (KR); Seo, Tae Wook, Pyungtaek-city Kyungki-do (KR)
(74) Representative: Leszczynski, André

(56) References cited:
- WO-A-20/04062341
- US-A1- 2002 187 261
- US-A1- 2004 216 671
- US-A1- 2004 237 893

## Description

### CROSS-REFERENCE TO RELATED PATENT APPLICATION

### BACKGROUND OF THE INVENTION

### 1. Field of the Invention

The present invention relates to a thin film deposition method, and more particularly, to a method of efficiently depositing a thin film on a substrate using an impulse feeding process.

### 2. Description of the Related Art

A current trend in the semiconductor industry is to make an ultrafine circuit linewidth and to constantly lower a thin film deposition temperature, achieving desired results in many processes. An atomic layer deposition (ALD) process is a widely known representative process that achieves the desired results.

Efforts to develop the ALD process were initiated in the semiconductor industry in the late 90s, and the ALD process has been actively developed up to now. However, the ALD process, in the traditional and narrow meaning, where alternating pulses using two kinds of reaction gases are created and an operation of interposing a purge gas between the pulses (purge operation) is repeated, is not effective when forming thin films. Such thin films include TiN and Ti. For example, when a TiN thin film is deposited using a traditional single-wafer ALD process, the purity and step coverage of the thin film are excellent, but productivity is two low.

Layer deposition methods are disclosed in WO 2004/062341, US 2004/237893 and 2002/187261.

### SUMMARY OF THE INVENTION

The present invention provides a method of depositing a thin film on a substrate, which can enhance the purity of the thin film while reducing the deposition time.

According to the present invention, there is provided a method of depositing a thin film on a substrate, the method including: simultaneously performing a second reaction gas discontinuous feeding process of discontinuously feeding a second reaction gas into a chamber in which a substrate is installed and a purge gas continuous feeding process of continuously feeding a purge gas onto the substrate; and performing a number of times, during the second reaction gas discontinuous feeding process, a process cycle including a first reaction gas feeding process of feeding a first reaction gas into the chamber and a first reaction gas purge process of purging the first reaction gas that is not adhered onto the substrate, wherein the second reaction gas discontinuous feeding process includes a second reaction gas impulse process of feeding the second reaction gas at an impulse flow rate greater than a basic flow rate during the first reaction gas purge process, and a second reaction gas feeding stop process of performed from the end of the second reaction gas impulse process to the start of a first reaction gas feeding process of the next process cycle; and the purge gas continuous feeding process includes a purge gas impulse process of feeding the purge gas at an impulse flow rate greater than a basic flow rate, preformed simultaneously with the second reaction gas feeding stop process.

### BRIEF DESCRIPTION OF THE DRAWINGS

The above and other features and advantages of the present invention will become more apparent by describing in detail exemplary embodiments thereof with reference to the attached drawings in which:
FIG. 1 illustrates a process sequence of a thin film deposition method according to an embodiment of the present invention;
FIG. 2 illustrates a process sequence of a thin film deposition method according to another embodiment of the present invention;
FIG. 3 illustrates a process sequence of a thin film deposition method according to another embodiment of the present invention;
FIG. 4 illustrates a process sequence of a thin film deposition method according to another embodiment of the present invention; and
FIG. 5 illustrates a process sequence of a thin film deposition method according to another embodiment of the present invention.

### DETAILED DESCRIPTION OF THE INVENTION

The present invention will now be described more fully with reference to the accompanying drawings, in which exemplary embodiments of the invention are shown.

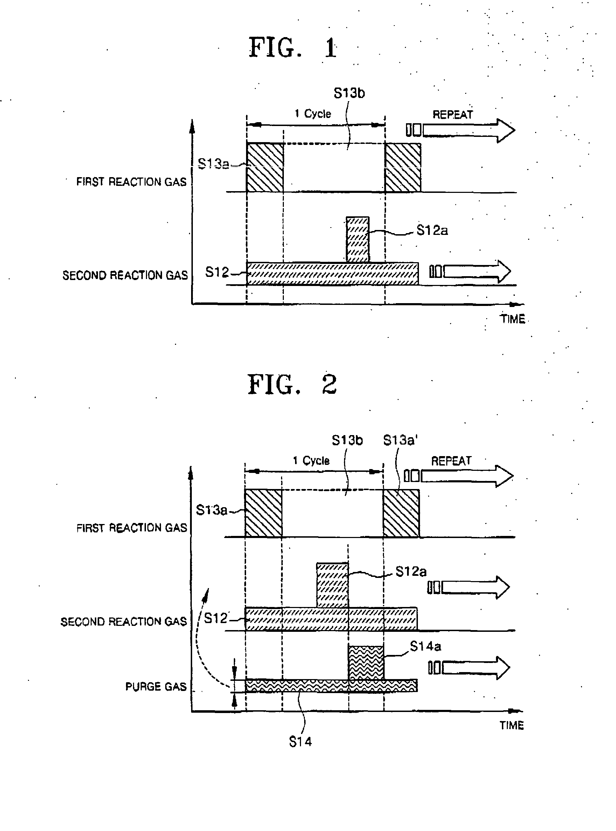

FIG. 1 illustrates a process sequence of a thin film deposition method according to an embodiment of the present invention.

Referring to FIG. 1, the thin film deposition method includes: performing a second reaction gas continuous feeding process S12 of continuously feeding a second reaction gas into a chamber in which a substrate is installed; and performing a number of times, during the second reaction gas continuous feeding process S12, a process cycle including a first reaction gas feeding process S13a of feeding a first reaction gas into the chamber and a first reaction gas purge process S13b of purging the first reaction gas that is not adhered onto the substrate.

The second reaction gas continuous feeding process S12 includes a second reaction gas impulse process S12a of feeding the second reaction gas at an impulse flow rate greater than a basic flow rate during the first reaction gas purge process S13b.

FIG. 2 illustrates a process sequence of a thin film deposition method according to another embodiment of the present invention.

Referring to FIG. 2, the thin film deposition method includes: simultaneously performing a second reaction gas continuous feeding process S12 of continuously feeding a second reaction gas into a chamber in which a substrate is installed and a purge gas continuous feeding process S14 of continuously feeding a purge gas onto the substrate; and performing a number of times, during the second reaction gas continuous feeding process S12, a process cycle including a first reaction gas feeding process S13a of feeding a first reaction gas into the chamber and a first reaction gas purge process S13b of purging the first reaction gas that is not adhered onto the substrate.

The second reaction gas continuous feeding process S12 includes a second reaction gas impulse process S12a of feeding the second reaction gas at an impulse flow rate greater than a basic flow rate during the first reaction gas purge process S13b.

The purge gas continuous feeding process S14 includes a purge gas impulse process S14a of feeding the purge gas at an impulse flow rate greater than a basic flow rate of a flow from the end of the second reaction impulse process S12a to the start of a first reaction gas feeding process S13a' of the next process cycle.

As described above, unlike the thin film deposition method of the embodiment of FIG. 1, thin film deposition method of the embodiment of FIG. 2 further includes: the purge gas continuous feeding process S14 performed during the process cycle; and the purge gas impulse process S14a performed from the end of the second reaction impulse process S12a to the start of a first reaction gas feeding process S13a' of the next process cycle.

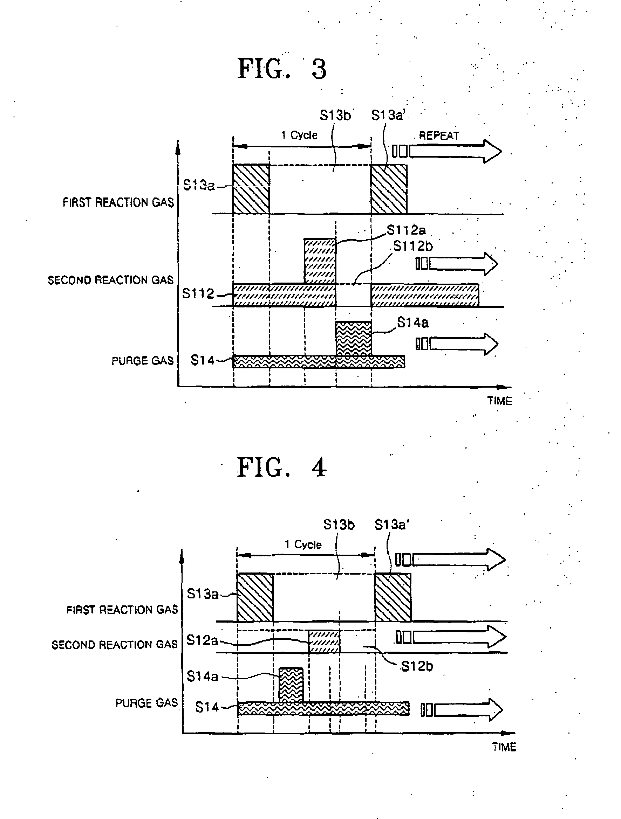

FIG. 3 illustrates a process sequence of a thin film deposition method according to another embodiment of the present invention.

Referring to FIG. 3, the thin film deposition method includes: simultaneously performing a second reaction gas discontinuous feeding process S112 of discontinuously feeding a second reaction gas into a chamber in which a substrate is installed and a purge gas continuous feeding process S14 of continuously feeding a purge gas onto the substrate; and performing a number of times, during the second reaction gas discontinuous feeding process S112, a process cycle including a first reaction gas feeding process S13a of feeding a first reaction gas into the chamber and a first reaction gas purge process S13b of purging the first reaction gas that is not adhered onto the substrate.

The second reaction gas discontinuous feeding process S112 includes: a second reaction gas impulse process S112a of feeding the second reaction gas at an impulse flow rate greater than a basic flow rate during the first reaction gas purge process S13b; and a second reaction gas feeding stop process S112b performed from the end of the second reaction gas impulse process S112a to the start of a first reaction gas feeding process S13a' of the next process cycle.

The purge gas continuous feeding process S14 includes a purge gas impulse process S14a of feeding the purge gas at an impulse flow rate greater than a basic flow rate, performed simultaneously with the second reaction gas feeding stop process S112b.

As described above, unlike the thin film deposition method of the embodiment of FIG. 2, the thin film deposition method of the embodiment of FIG. 3 includes: the second reaction gas discontinuous feeding process S112 including the second reaction gas impulse process S112a and the second reaction gas feeding stop process S112b; and the purge gas continuous feeding process S14 including the purge gas impulse process S14a performed simultaneously with the second reaction gas feeding stop process S112b.

FIG. 4 illustrates a process sequence of a thin film deposition method according to another embodiment of the present invention.

Referring to FIG. 4, the thin film deposition method includes: performing a number of times a process cycle including a first reaction gas feeding process S13a of feeding a first reaction gas into a chamber in which a substrate is installed, a first reaction gas purge process S13b of purging the first reaction gas that is not adhered onto the substrate, a second reaction gas feeding process 12a of feeding a second reaction gas into the chamber, and a second reaction gas purge process S12b of purging reaction by-products produced by reaction with the first reaction gas floating over the substrate or the second reaction gas not reacting with the first reaction gas adhered onto the substrate; and performing a purge gas continuous feeding process S14 of continuously feeding a purge gas onto the substrate during the repeated process cycles.

The purge gas continuous feeding process S14 includes a purge gas impulse process S14a of feeding the purge gas onto the substrate at an impulse flow rate greater than a basic flow rate of a flow. The purge gas impulse process S14a starts after the first reaction gas feeding process S13a and ends before the second reaction gas feeding process S12a.

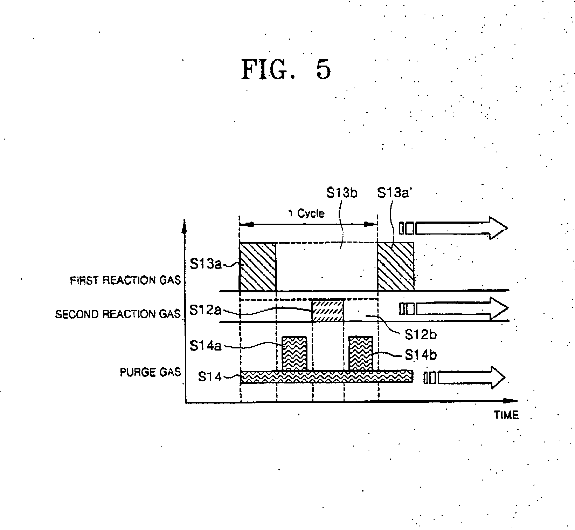

FIG. 5 illustrates a process sequence of a thin film deposition method according to another embodiment of the present invention.

Referring to FIG. 5, the thin film deposition method includes: performing a number of times a process cycle including a first reaction gas feeding process S13a of feeding a first reaction gas into a chamber in which a substrate is installed, a first reaction gas purge process S13b of purging the first reaction gas that is not adhered onto the substrate, a second reaction gas feeding process 12a of feeding a second reaction gas into the chamber, and a second reaction gas purge process S12b of purging reaction by-products produced by reaction with the first reaction gas floating over the substrate or the second reaction gas not reacting with the first reaction gas adhered onto the substrate; and performing a purge gas continuous feeding process S14 of continuously feeding a purge gas onto the substrate during the repeated process cycles.

The purge gas continuous feeding process S14 includes: a first purge gas impulse process S14a of feeding a purge gas at an impulse flow rate greater than a basic flow rate of a flow, the first purge gas impulse process S14a starting after the first reaction gas feeding process S13a and ending before the second reaction gas feeding process S12a; and a second purge gas impulse process S14b of feeding a purge gas at an impulse flow rate greater than a basic flow rate of a flow, the second purge gas impulse process S14b starting after the second reaction gas feeding process S12a and ending before a first reaction gas feeding process S13a' of the next process cycle.

As described above, unlike the thin film deposition method of the embodiment of FIG. 4, the thin film deposition method of the embodiment of FIG. 5 includes: the first purge gas impulse process S14a starting after the first reaction gas feeding process S13a and ending before the second reaction gas feeding process S12a; and the second purge gas impulse process S14b staring after the second reaction gas feeding process S12a and ending before a first reaction gas feeding process S13a' of the next process cycle.

When compared to the conventional ALD thin film deposition method, the thin film deposition method of the above embodiments can provide an increased deposition speed, enhanced step coverage, and enhanced purity of the thin film due to the following three reasons.

The first reason is that the second reaction gas is fed continuously in the thin film deposition methods of the aforementioned embodiments in contrast with the conventional ALD thin film deposition method in which a second reaction gas is fed discontinuously. The second reason is that the purge gas is fed continuously or discontinuously. The third reason is that the second reaction gas and the purge gas are fed at the basic flow rates or at the impulse flow rates. Due to these three reasons, the non-reaction gas or the reaction by-product remaining on the substrate can be rapidly flowed to the outside of the substrate and a thermolytic substitution reaction with the first reaction gas adhered onto the substrate can be performed densely and rapidly.

Examples of process applications for the above embodiments will now be described in detail.

In a process application, the first reaction gas is vaporized from a precursor liquid material containing a metallic element, or gas outputted from a compressed gas container. The second reaction gas is a reaction gas containing H (hydrogen). The thin film deposited using the first and second reaction gases is a thin film containing the above metallic element, such as a Ti thin film, a W thin film, a Ta thin film, and a Ru thin film.

In another process application, the first reaction gas is vaporized from a precursor liquid material containing a metallic element, or gas outputted from a compressed gas container. The second reaction gas is a reaction gas containing N (Nitrogen). The thin film deposited using the first and second reaction gases is a metal nitride thin film containing the above metallic element, such as a TiN thin film, a WN thin film, and a TaN thin film. For the TiN thin film, the first reaction gas is one selected from the group consisting of TICl₄, TEMATi, TDMAti, and a combination thereof, and the second reaction gas is NH₃.

Also, depending on the kind of the thin film and the environment of the process chamber, the deposition is performed at a chamber pressure of 13.3-1330 Pa (0.1 -10 torr) and at a substrate temperature of 600°C or below.

As described above, unlike the conventional ALD thin film deposition method, the thin film deposition method of the present invention further includes an impulse feeding process of feeding the second reaction gas or the purge gas at the impulse flow rate lower than the basic flow rate, thereby enhancing the deposition speed and characteristics of the thin film.

## Claims

1. A method of depositing a thin film on a substrate, the method comprising:
simultaneously performing a second reaction gas discontinuous feeding process of discontinuously feeding a second reaction gas into a chamber in which a substrate is installed and a purge gas continuous feeding process of continuously feeding a purge gas onto the substrate; and
performing a number of times, during the second reaction gas discontinuous feeding process, a process cycle comprising a first reaction gas feeding process of feeding a first reaction gas into the chamber and a first reaction gas purge process of purging the first reaction gas that is not adhered onto the substrate,
wherein the second reaction gas discontinuous feeding process comprises a second reaction gas impulse process of feeding the second reaction gas at an impulse flow rate greater than a basic flow rate during the first reaction gas purge process, and a second reaction gas feeding stop process performed from the end of the second reaction gas impulse process to the start of a first reaction gas feeding process of the next process cycle, **characterized in that** the purge gas continuous feeding process comprises a purge gas impulse process of feeding the purge gas at an impulse flow rate greater than a basic flow rate, performed simultaneously with the second reaction gas feeding stop process.

2. The method of claim 1, wherein the first reaction gas is vapor vaporized from a precursor liquid material containing a metallic element, or gas outputted from a compressed gas container; the second reaction gas is a reaction gas containing H (hydrogen); and the thin film deposited using the first and second reaction gases is a thin film containing the metallic element.

3. The method of claim 2, wherein the thin film is one of a Ti thin film, a W thin film, a Ta thin film, and a Ru thin film.

## Patentansprüche

1. Verfahren zum Aufbringen eines dünnen Films auf ein Substrat, wobei
gleichzeitig ein Prozeß zum diskontinuierlichen Zuführen eines zweiten Reaktionsgases in eine Kammer, in der ein Substrat angeordnet ist, und ein Prozeß zum kontinuierlichen Zuführen eines Reinigungsgases auf das Substrat durchgeführt werden, und
während des Prozesses zum diskontinuierlichen Zuführen des zweiten Reaktionsgases mehrere Male ein Prozeßzyklus durchgeführt wird, der einen Prozeß zum Zuführen eines ersten Reaktionsgases in die Kammer und einen Prozeß zum Reinigen des ersten Reaktionsgases, das nicht an dem Substrat anhaftet, aufweist,
wobei der Prozeß zum diskontinuierlichen Zuführen des zweiten Reaktionsgases einen Impulsprozeß zum Zuführen des zweiten Reaktionsgases mit einer lmpulsströmungsrate, die größer ist als eine Basisströmungsrate während des Prozesses zum Reinigen des ersten Reaktionsgases, und einen Prozeß zum Unterbrechen der Zufuhr des zweiten Reaktionsgases, der nach Beendigung des Impulsprozesses des zweiten Reaktionsgases bis zum Beginn eines Prozesses zum Zuführen des ersten Reaktionsgases beim nächsten Prozeßzyklus durchgeführt wird, aufweist, **dadurch gekennzeichnet, daß** der Prozeß zum kontinuierlichen Zuführen des Reinigungsgases einen Impulsprozeß zum Zuführen des Reinigungsgases mit einer Impulsströmungsrate aufweist, die größer ist als eine Basisströmungsrate, der gleichzeitig mit dem Prozeß zum Beendigen des Zuführens des zweiten Reaktionsgases durchgeführt wird.

2. Verfahren nach Anspruch 1, wobei das erste Reaktionsgas Dampf ist, der aus einem ein metallisches Element enthaltendem flüssigen Vorläufermaterial verdampft ist, oder aus einem Kompressionsgasbehälter ausgegebenes Gas; das zweite Reaktionsgas ein H (Wasserstoff) enthaltendes Reaktionsgas ist; und der das erste und das zweite Reaktionsgas verwendende aufgebrachte dünne Film ein das metallische Element enthaltender dünner Film ist.

3. Verfahren nach Anspruch 2, wobei der dünne Film ein Ti-Dünnfilm, ein W-Dünnfilm, ein Ta-Dünnfilm, oder ein Ru-Dünnfilm ist.

## Revendications

1. Procédé pour déposer un film mince sur un substrat, le procédé comportant les étapes consistant à :
exécuter simultanément un processus de transfert discontinu de second gaz de réaction consistant à transférer de manière discontinue un second gaz de réaction dans une chambre dans laquelle un substrat est installé, et un processus de transfert continu de gaz de purge consistant à transférer de manière continue un gaz de purge sur le substrat, et
exécuter plusieurs fois, pendant le processus de transfert discontinu de second gaz de réaction, un cycle de traitement comportant un processus de transfert de premier gaz de réaction consistant à transférer un premier gaz de réaction dans la chambre, et un processus de purge de premier gaz de réaction consistant à purger le premier gaz de réaction qui n'a pas adhéré au substrat,
dans lequel le processus de transfert discontinu de second gaz de réaction comporte un processus d'impulsion de second gaz de réaction consistant à transférer le second gaz de réaction à un débit d'impulsions supérieur à un débit de base pendant le processus de purge de premier gaz de réaction, et un processus d'arrêt de transfert de second gaz de réaction exécuté de la fin du processus d'impulsion de second gaz de réaction jusqu'au début d'un processus de transfert de premier gaz de réaction du cycle de traitement suivant, **caractérisé en ce que** le processus de transfert continu de gaz de purge comporte un processus d'impulsion de gaz de purge consistant à transférer le gaz de purge à un débit d'impulsions supérieur à un débit de base, exécuté simultanément au processus d'arrêt de transfert de second gaz de réaction.

2. Procédé selon la revendication 1, dans lequel le premier gaz de réaction est vaporisé sous forme de vapeur à partir d'un liquide précurseur contenant un élément métallique, ou est délivré en sortie sous forme de gaz à partir d'un conteneur de gaz comprimé, le second gaz de réaction est un gaz de réaction contenant H (hydrogène), et le film mince déposé en utilisant les premier et second gaz de réaction est un film mince contenant l'élément métallique.

3. Procédé selon la revendication 2, dans lequel le film mince est un élément parmi un film mince de Ti, un film mince de W, un film mince de Ta et un film mince de Ru.
